# EUROPÄISCHE PATENTSCHRIFT

(11) **EP 0 365 988 B1**
(45) Veröffentlichungstag und Bekanntmachung des Hinweises auf die Patenterteilung: **15.06.1994**
(21) Anmeldenummer: 89119314.6
(22) Anmeldetag: 18.10.1989
(51) Int. Cl.: G03F 7/32

(54) **Entwicklungslösemittel für durch Photopolymerisation vernetzbare Schichten sowie Verfahren zur Herstellung von Reliefformen**
Developing solvent for layers which are crosslinkable by photopolymerization, and process for the production of relief printing forms
Solvant pour le développement de couches réticulées par photopolymérisation et procédé de fabrication de formes en relief

(30) Priorität: 26.10.1988 DE 3836403
(43) Veröffentlichungstag der Anmeldung: 02.05.1990
(73) Patentinhaber: E.I. DU PONT DE NEMOURS & COMPANY INCORPORATED, Wilmington Delaware 19898 (US)
(72) Erfinder: Schlosser, Hans-Joachim, Dr. Dipl.-Chem., D-6200 Wiesbaden (DE); Schön, Günther, D-6200 Wiesbaden (DE)
(74) Vertreter: Pistor, Wolfgang, Dipl.-Chem.

(56) Entgegenhaltungen:
- FR-A- 2 163 896
- FR-A- 2 291 607
- FR-A- 2 455 076
- CHEMICAL ABSTRACTS, Band 96, 1982, Seite 456, Zusammenfassung Nr. 26858t, Columbus, Ohio, US; & SU-A-866 793
- PATENT ABSTRACTS OF JAPAN, Band 7, Nr. 253 (P-235)[1398], 10. November 1983; & JP-A-58 137 836

## Beschreibung

Die Erfindung betrifft ein Verfahren zur Herstellung von durch Photopolymerisation vernetzten Reliefdruckplatten, bei dem man die durch Photopolymerisation vernetzbaren Schichten bildmäßig belichtet und die unvernetzten Anteile der Schichten mit dem Entwicklungslösemittel auswäscht.

Die Herstellung von Reliefformen, insbesondere von Flexodruckplatten, durch bildmäßiges Belichten und anschließendes Entwickeln und Auswaschen von durch Photopolymerisation vernetzbaren Schichten ist seit langem bekannt.

Zur Herstellung solcher Formen wird die Photopolymerschicht bildmäßig mit aktinischem Licht belichtet; die Ausbildung des Reliefs wird anschließend durch Auswaschen der nicht belichteten und damit nicht vernetzten Anteile der Schicht mit dem Entwicklungslösemittel ermöglicht. Aufgabe des Entwicklungslösemittels ist es, die nicht vernetzten Anteile der Schicht möglichst schnell zu lösen, wobei das Lösemittel andererseits aber von den vernetzten Anteilen der Platte möglichst leicht zu entfernen sein muß, damit die Platte schnell trocken ist.

Eingesetzt werden daher heute zumeist Entwicklungslösemittel mit niedrigem Siedepunkt.

In der DE-A 22 15 090 werden z. B. Methylethylketon, Benzol, Toluol, Xylol, Tetrachlorkohlenstoff, Trichlorethan, Trichlorethylen, Methylchloroform und Tetrachlorethan sowie deren Gemische als geeignete Lösemittel beschrieben. Nachteilig bei den genannten chlorierten Kohlenwasserstoffen sind Toxizität und Entsorgungsprobleme. Werden chlorierte Kohlenwasserstoffe als Entwicklungslösemittel verwendet, quellen die zu entfernenden Bereiche schon auf der Platte sehr stark, und die steigende Konzentration der im Entwicklungslösemittel gelösten Bestandteile der nicht vernetzten Anteile der Schicht führt zu einer starken Viskositätszunahme des Lösemittels. Dies hat zur Folge, daß die Kapazität des Entwicklungslösemittels sehr beschränkt ist und schon bei einer 5%igen Beladung das Lösemittel unbrauchbar wird. Eine weitere Folge der starken Viskositätszunahme ist, daß die Platten auch schon bei einer Beladung von weniger als 5 % sehr langsam zu entwickeln sind. Außerdem ist die Entwicklung von Platten, die Nitrilkautschuke als Elastomere enthalten, sehr langsam.

Von den in der DE-A 22 15 090 genannten nicht chlorierten Kohlenwasserstoffen sind Benzol, Toluol und Xylol zu nennen. Diese Lösemittel weisen als nachteilig auf, daß sie leicht brennbar sind und außerdem zu einer starken Quellung der Schicht und folglich nur zu einer langsamen Entwicklung und Trocknung der Platte führen.

Wegen ihres niedrigen Flammpunktes ist zudem ihr Einsatz in nicht explosionsgeschützten Entwicklungsgeräten nicht möglich.

In der DE-A 36 00 116 werden höhersiedende Entwicklungslösemittel beschrieben, die als wesentliche Bestandteile verzweigte, einfach oder dreifach olefinisch ungesättigte cyclische oder gesättigte oder einfach bis dreifach olefinisch ungesättigte cyclische aliphatische Kohlenwasserstoffe, Alkohole oder Ketone enthalten. Insbesondere werden Monoterpene genannt. Das im Beispiel verwendete Limonen besitzt zwar gute Entwicklungseigenschaften, ist aber sauerstoffempfindlich und hautreizend, Eigenschaften, die ein Entwicklungslösemittel nicht aufweisen sollte. Ein weiterer Nachteil ist, daß Limonen nur eine sehr langsame Entwicklung erlaubt und schwer aus der Schicht zu entfernen ist. Außerdem ist eine Entwicklung von Platten, die Nitrilkautschuke enthalten, nicht innerhalb vernünftiger Zeit möglich.

Aufgabe war es daher, ein Verfahren zum Entwickeln von Photopolymerschichten mit einem Entwicklungslösemittel bereitzustellen, bei dem das Lösemittel
- nicht toxisch ist,
- einen hohen Flammpunkt besitzt,
- möglichst vollständig und schnell aus der Schicht entfernbar ist, ohne die Schicht zu quellen,
- sowie eine möglichst geringe Viskositätszunahme bei Aufnahme von Bestandteilen der Schicht aufweist, die es ermöglicht, trotz geforderter hoher Kapazität, schnell und einwandfrei entwickeln zu können,
- Platten, die Nitrilkautschuke als Elastomere enthalten, schnell entwickelt.

Die Lösung der Aufgabe wird durch ein Verfahren der eingangs beschriebenen Gattung erreicht das dadurch gekennzeichnet ist, daß das Entwicklungslösemittel als wesentlichen Bestandteil eine aromatische Verbindung der allgemeinen Formel I 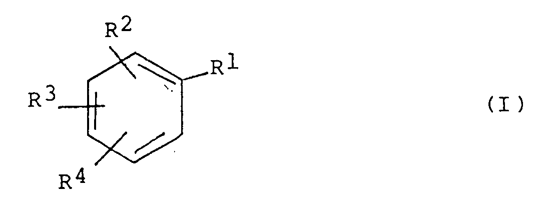
enthält, worin
- R¹ bis R⁴: gleich oder verschieden sein können und H, (C₁-C₅)n- oder iso-Alkyl bedeuten, wobei R¹ und R², sofern sie direkt benachbart sind, auch einen cycloaliphatischen oder aromatischen Ring mit 5 oder 6 Ring-C-Atomen ausbilden können, die bevorzugt nicht substituiert sind,
mit der Maßgabe, daß die Summe der Kohlenstoffatome der Substituenten und der Ringglieder 9 bis 13 ist.

Besonders bevorzugt sind aromatische Verbindungen der allgemeinen Formel I, in denen die Zahl der Kohlenstoffatome 9 bis 11 (insbesondere 9 oder 10) beträgt.

Ebenso bevorzugt sind diejenigen aromatischen Verbindungen der allgemeinen Formel I, in denen die Summe der Kohlenstoffatome der Substituenten 3 bis 5 beträgt, sofern R¹ und R² nicht zu einem cycloaliphatischen oder cycloaromatischen Ring geschlossen sind. In diesem Fall ist die Summe der Kohlenstoffatome der übrigen Reste R gleich Null, d. h. R³ und R⁴ bedeuten H.

Als Ringsysteme, die durch Verbrückung der Reste R¹ und R² gebildet werden können, sind Indan, Inden, Naphthalin und Tetralin zu nennen. Bevorzugt sind aber die C-9-Ringsysteme Indan und Inden.

Ist die Summe der Kohlenstoffatome in den Substituenten gleich 5, so wird diese Zahl 5 bevorzugt durch einen einzigen Pentylrest erreicht (z. B. R¹ = Pentyl), während R² bis R⁴ H bedeuten.

Ist die Summe der Kohlenstoffatome in den Substituenten gleich 3, so wird diese Zahl bevorzugt durch drei Methylgruppen, eine Methylgruppe und eine Ethylgruppe oder eine Propylgruppe erzeugt.

Ist die Summe der Kohlenstoffatome in den Substituenten gleich 4, so wird diese Zahl durch vier Methylgruppen, eine Methylgruppe und eine Propylgruppe, zwei Ethylgruppen, zwei Methylgruppen und eine Ethylgruppe oder eine Butylgruppe gebildet.

Insbesondere bevorzugt sind folgende aromatische Verbindungen:
Iso-propylbenzol, n-Propylbenzol, 1-Methyl-3-ethylbenzol, 1,3,5-Trimethylbenzol, 1-Methyl-2-ethylbenzol, 1,2,4-Trimethylbenzol, Isobutylbenzol, sec-Butylbenzol, 1,2,3-Trimethylbenzol, 1-Methyl-4-isopropylbenzol, Indan, Inden, 1,3-Diethylbenzol, 1-Methyl-4-propylbenzol, n-Butylbenzol; 1-Methyl-3-propylbenzol, 1,2,4,5-Tetramethylbenzol, Dimethylethylbenzol, Methylindan, n-Pentylbenzol.

Das Entwicklungslösemittel kann aromatische Verbindungen der allgemeinen Formel I sowohl einzeln als auch als Gemisch verschiedener aromatischer Verbindungen, die unter die allgemeine Formel I fallen, enthalten.

Das in dem erfindungsgemäßen Verfahren verwendete Entwicklungslösemittel enthält 55 bis 100 % Gew.-%, insbesondere 55 bis 90 Gew.-%., aromatische Verbindungen der allgemeinen Formel I.

Neben den Verbindungen der allgemeinen Formel I kann das Entwicklungslösemittel andere Losemittel als Zusätze enthalten, insbesondere dann, wenn die Polymerschicht noch eine polyamidhaltige Schutzschicht enthält. In diesem Fall werden als zusätzliche Lösemittel Alkohole, insbesondere höhersiedende Alkohole, bevorzugt.

Die mit dem Entwicklungslösemittel zu entwickelnden, durch Photopolymerisation vernetzbaren Schichten enthalten als Hauptbestandteile im wesentlichen ein Bindemittel auf der Basis eines elastomeren Polymeren, ein mit dem Bindemittel verträgliches photopolymerisierbares Monomeres und einen Photoinitiator. Die Schichten können auch mehrere verschiedene andere Bindemittel, Monomere oder Photoinitiatoren enthalten.

Als Zusätze können die Schichten Farbstoffe, Pigmente, Lichthofschutzmittel, Antioxidantien, Weichmacher, Antiozonantien, Vernetzungsmittel, Regler, Füllmittel, Flußmittel und andere Mittel, die die Schicht in ihrer Wirkungsweise verbessern, enthalten.

Weitere Hilfsmittel, die der beschriebenen Schicht zugesetzt werden können, sind z. B. Inhibitoren der thermischen Polymerisation wie Hydrochinon und seine Derivate, 2,6-Di-tert.-butyl-p-kresol, Nitrophenole, Nitrosamine wie N-Nitrosodiphenylamin oder Salze des N-Nitrosocyclohexylhydroxylamins, z. B. dessen Alkali- oder Aluminiumsalze.

Besonders bevorzugt sind solche durch Photopolymerisation vernetzbare Schichten, die als Bindemittel Polymerisate von konjugierten aliphatischen Dienen, deren Monomerbausteine 4 bis 5 Kohlenstoffatome aufweisen, enthalten. Insbesondere sind hierbei zu nennen Naturkautschuk, Homopolymerisate von Butadien und Isopren, Copolymerisate von Butadien und Isopren, Copolymerisate von Butadien und/oder Isopren mit anderen Monomeren, wie Styrol, Vinyltoluol, Acrylnitril oder (Meth)Acrylsäurealkylester, z. B. Nitrilkautschuke nach der EP-A 064 564, statistische Styrol/Butadien-, -/Isopren-, und -/Isopren/Butadien-Copolymerisate oder Blockpolymerisate aus Styrolmonomeren und Butadien und/oder Isopren mit einem Styrolgehalt von 10 bis 50 Gew.-%. Elastomere dieser Art werden in den DE-B 22 15 090, DE-A 24 56 439, DE-A 29 42 183 und DE-A 21 38 582 beschrieben.

Die durch Photopolymerisation vernetzbaren Schichten enthalten im allgemeinen 20 bis 95, vorzugsweise 30 bis 95 Gew.-% Bindemittel.

Geeignete Monomere mit einer oder mehreren polymerisierbaren olefinischen Doppelbindungen sind insbesondere Ester und Amide von Acryl- und Methacrylsäure. Beispiele sind die verträglichen Mono- und Diacrylate sowie -methacrylate von ein- oder mehrwertigen Alkoholen, wie Ethylenglykol, Di-, Tri-, Tetra- oder Polyethylenglykolen, letztere bevorzugt mit 10 bis 15 Ethylenglykoleinheiten, 1,3-Propandiol, 1,6-Hexandiol, Dodecandiol, Glycerin, 1,1,1-Trimethylolpropan, 1,2,4-Butantriol oder Pentaerythrit, z. B. Ethylenglykol-monomethacrylat, 1,3-Propandiol-monomethacrylat, Hexandioldiacrylat, Hexandioldimethacrylat, 2-Ethylhexylacrylat, Laurylmethacrylat, Stearylmethacrylat, Glycerinmono- oder -diacrylat, 1,2,4-Butantriolmonomethacrylat, Pentaerythrittriacrylat, Polyethylenglykolmethyletheracrylat, Tetradecaethylenglykoldimethacrylat oder der Triether aus Glycerin und 3 mol N-Methylolacrylamid oder -methacrylamid. Die Menge an Monomeren in der Schicht liegt im allgemeinen bei 1 bis 70, bevorzugt bei 2 bis 50 Gew.-% der nichtflüchtigen Bestandteile des Gemisches.

Als Photoinitiatoren kommen die bekannten Verbindungen in Frage, die eine hinreichende thermische Stabilität bei der Verarbeitung der Aufzeichnungsmaterialien sowie eine hinreichende Radikalbildung bei Belichtung unter Initiierung der Polymerisation der Monomeren aufweisen. Sie sollen Licht im Wellenlängenbereich von ca. 250 bis 500 nm unter Bildung von Radikalen absorbieren. Beispiele geeigneter Photoinitiatoren sind Acyloine und deren Derivate wie Benzoin, Benzoinalkylether, z. B. Benzoinisopropylether, vicinale Diketone und deren Derivative, z. B. Benzil, Benzilacetale wie Benzildimethylketal, Fluorenone, Thioxanthone, Mehrkernchinone, Acridine und Chinoxaline; ferner Trichlormethyl-s-triazine, 2-Halogenmethyl-4-vinyl-1,3,4-oxadiazolderivate, mit Trichlormethylgruppen substituierte Halogenoxazole, Trihalogenmethylgruppen enthaltende Carbonylmethylenheterocyclen gemäß DE-A 33 33 450, Acylphosphinoxidverbindungen, wie sie z. B. in der DE-A 31 33 419 beschrieben sind, und andere phosphorhaltige Photoinitiatoren, z.B. die in der deutschen Patentanmeldung P 38 27 735.2 beschriebenen 6-Acyl-(6H)-dibenz-[c,e][1,2]-oxaphosphorin-6-oxide, insbesondere das 6-(2,4,6-Trimethylbenzoyl)-(6H)dibenz-[c,e][1,2]-oxaphosphorin-6-oxid.

Die Photoinitiatoren lassen sich auch in Kombination miteinander oder mit Coinitiatoren bzw. Aktivatoren verwenden, z. B. mit Michlers Keton und seinen Derivaten oder 2-Alkyl-anthrachinonen. Die Menge an Photoinitiator beträgt im allgemeinen 0,01 bis 10, bevorzugt 0,5 bis 5 Gew.-% der Schicht.

Die durch Photopolymerisation vernetzbaren Gemische lassen sich für die Herstellung von Relief- und Flexodruckplatten durch Gießen aus Lösung oder Extrudieren und Kalandrieren zu Schichten einer Dicke von 0,02 bis 10, vorzugsweise von 0,2 bis 6 mm, ausformen. Die Schicht kann auf die Oberfläche eines geeigneten Trägers laminiert oder es kann eine Lösung des Gemisches auf einen Schichtträger aufgebracht werden.

Außer für die Herstellung von Reliefdruckplatten werden die genannten Schichten auch z. B. zur Herstellung von Flachdruckplatten, Tiefdruckzylindern, Siebdruckschablonen und Photoresists verwendet.

Geeignete Träger sind je nach Verwendungszweck, z. B. Polyesterfolien, Stahl- oder Aluminiumbleche, Kupferzylinder, Siebdruckschablonenträger, Schaumstofflagen, gummielastische Träger oder Leiterplatten. Es kann auch vorteilhaft sein, auf die lichtempfindliche Aufzeichnungsschicht eine Deck- bzw. Schutzschicht, z. B. eine dünne Schicht aus Polyvinylalkohol oder Polyamid, oder eine abziehbare Deckfolie, z. B. aus Polyethylenterephthalat, aufzubringen. Weiterhin kann eine Vorbeschichtung des Trägers vorteilhaft sein. Die zusätzliche Schicht zwischen dem Träger und der lichtempfindlichen Schicht kann z. B. als Lichthofschutzschicht oder als Haftschicht wirksam sein.

Die durch Photopolymerisation vernetzbaren Schichten werden bildmäßig mit aktinischem Licht aus Lichtquellen wie Quecksilberdampflampen oder Leuchtstoffröhren belichtet, wobei die emittierte Wellenlänge bei 230 bis 450 nm, bevorzugt zwischen 300 und 420 nm liegt. Das Entfernen der unbelichteten und unvernetzten Schichtanteile erfolgt mit dem erfindungsgemäßen Entwicklungslösemittel durch Sprühen, Waschen oder Bürsten. Zweckmäßig werden die entwickelten Reliefformen bei Temperaturen bis 120 °C getrocknet und gegebenenfalls gleichzeitig oder danach mit aktinischem Licht nachbelichtet.

Die durch Photopolymerisation vernetzten Reliefformen eignen sich besonders zur Herstellung von Druckformen, vor allem Hoch- und Reliefdruckformen, die besonders für den Flexodruck geeignet sind.

Die Erfindung wird durch die nachstehenden Beispiele erläutert.

### Beispiel 1

Eine handelsübliche Flexodruckplatte auf der Basis eines Dreiblockpolymerisats aus Styrol-Isopren-Styrol als Elastomeres (®Cyrel HL) mit einer Schichtdicke von 2,8 mm wurde zunächst von der Rückseite her mit einem handelsüblichen Röhrenbelichter vollflächig 76 s belichtet und anschließend durch eine aufgelegte Negativvorlage bildmäßig 12 min von der Vorderseite belichtet. Die in dieser Weise belichtete Platte wurde dann in einem handelsüblichen, mit Bürsten versehenen Entwicklungsgerät mit einem Gemisch aus aromatischen Kohlenwasserstoffen nach der allgemeinen Formel I der unten aufgeführten Zusammensetzung und einem Anteil von 15 Gew.-% Butanol entwickelt. Die Zeit, in der entwickelt wurde, um optimale Ergebnisse zu erreichen, betrug 5 min.

Anschließend wurde die Flexodruckform 2 h bei 60 °C getrocknet und 15 h bei Raumtemperatur gelagert. Nach üblicher Nachbehandlung mit einer wäßrigen Bromlösung ergab sich eine Flexodruckplatte von ausgezeichneter Qualität.

Zusammensetzung des Gemisches aromatischer Kohlenwasserstoffe:
2,7 % Gemisch von n-Propyl- und iso-Propylbenzol,
21,5 % Gemisch von verschiedenen isomeren Methylethylbenzolen,
50,6 % Gemisch von verschiedenen isomeren Trimethylbenzolen,
2,6 % Indan,
4,1 % Gemisch von verschiedenen isomeren Dimethyl-ethylbenzolen,
2,5 % Butylbenzol und
17 % Gemisch verschiedener Alkylbenzole mit 9 bis 11 Kohlenstoffatomen.

### Beispiel 2

Gemäß Beispiel 1 wurde eine handelsübliche Flexodruckplatte belichtet. Die belichtete Platte wurde dann in einem handelsüblichen Entwicklungsgerät mit dem Gemisch aus aromatischen Kohlenwasserstoffen aus Beispiel 1, allerdings zusammen mit 15 Gew.-% 2-Ethyl-butanol-(1) entwickelt. Die Zeit, in der entwickelt wurde, um optimale Ergebnisse zu erzielen, betrug 5 min. Anschließend wurde die Flexodruckform wie in Beispiel 1 nachbehandelt. Es ergab sich eine Flexodruckplatte von ausgezeichneter Qualität.

### Beispiel 3

Eine handelsübliche Flexodruckplatte wie aus Beispiel 1 wurde nach Abziehen der Deckschicht (Plattengröße 18x3 cm) 5 min mit einer Bürste gleichmäßig in 50 ml 1,3,5-Trimethyltoluol gerieben. Nach dem Trocknen und der Lagerung gemäß Beispiel 1 wurde eine Restschichtdicke von 1,28 mm erhalten.

Die Restschichtdicke ist - in Kombination mit der Zeit, die für die Entwicklung zur Verfügung stand - ein Maß für die Entwicklungsgeschwindigkeit. Je geringer die Restschichtdicke der ursprünglich 2,8 mm dicken Schicht ist, um so größer ist die Entwicklungsgeschwindigkeit des angewendeten Lösemittels.

### Beispiel 4

Es wurde entsprechend Beispiel 3 vorgegangen, mit der Ausnahme, daß als Entwicklungslösemittel 4-Isopropyltoluol benutzt wurde. Die Restschichtdicke betrug 1,27 mm.

### Beispiel 5

Entsprechend Beispiel 3 wurde verfahren, mit der Ausnahme, daß als Entwicklungslösemittel ein Gemisch aus aliphatisch-substituierten Aromaten, wie in Beispiel 1 beschrieben, verwendet wurde. Die ermittelte Restschichtdicke betrug 0,88 mm.

### Beispiel 6

Es wurde wie in Beispiel 5 verfahren, mit der Ausnahme, daß das Lösemittelgemisch aus Beispiel 2 benutzt wurde. Die Restschichtdicke betrug 0,4 mm.

### Beispiel 7 (Vergleichsbeispiel)

Entsprechend Beispiel 3 wurde eine Flexodruckplatte belichtet und entwickelt, diesmal mit Limonen als Entwicklungslösemittel. Es konnte eine Restschichtdicke von 1,53 mm ermittelt werden.

### Beispiel 8

Eine Flexodruckplatte gemäß Beispiel 1 wurde 76 s von der Rückseite vollflächig belichtet und anschließend durch Verwendung einer Negativvorlage von der Vorderseite 8 min belichtet. Nach Entfernen der Deckschicht wurde die Platte (30 mm Durchmesser) 5 min in 50 ml Mesitylen (1,3,5-Trimethyltoluol) gelegt. Anschließend wurde die Platte abgewischt, 2 h bei 60 °C getrocknet und 17 h gelagert. Es konnte eine Gewichtszunahme der Schicht von 1,97 % bestimmt werden.

### Beispiel 9

Es wurde wie in Beispiel 8 angegeben vorgegangen, mit der Ausnahme, daß als Entwicklungslösemittel Tetralin verwendet wurde. Die Gewichtszunahme betrug in diesem Fall 3,59 %.

### Beispiel 10

Es wurde wie in Beispiel 8 beschrieben vorgegangen, mit der Ausnahme, daß als Entwicklungslösemittel das Lösemittelgemisch aus Beispiel 1 benutzt wurde. Die Gewichtszunahme betrug 2,7 %.

### Beispiel 11 (Vergleichsbeispiel)

Es wurde wie in Beispiel 8 beschrieben vorgegangen, mit der Maßgabe, daß als Entwicklungslösemittel Perchlorethylen eingesetzt wurde. Die Gewichtszunahme der Schicht nach Entwicklung und Trocknung betrug 4,3 %.

### Beispiel 12

Zur Ermittlung des Aufnahmevermögens (Kapazität) von Entwicklungslösemitteln an den Bestandteilen aus nicht vernetzten Bereichen einer Flexodruckplatte (®Cyrel HL) wurde die Viskosität verschiedener Entwicklungslösemittel bei unterschiedlichen Festostoffgehalten von Bestandteilen aus der Schicht nach der Entwicklung einer Platte, enthaltend als Elastomer ein Dreiblockcopolymer aus Styrol-Isopren-Styrol, bestimmt.

Tabelle 1 zeigt Viskositätswerte, die in dem Ubbelohde-Viskosimeter bei 25 °C bestimmt wurden, für Feststoffgehalte von 5, 7,5 und 10 Gew.-%. Während die erfindungsgemäßen Entwicklungslösemittel bei einem Fest-stoffgehalt von 7,5 Gew.-% eine viskosität aufweisen, die eine sehr rasche Entwicklungsgeschwindigkeit ermöglicht, wird die Viskosität von Perchlorethylen schon bei einem Feststoffgehalt im Entwicklungslösemittel von 5 Gew.-% derart hoch, daß eine rasche Entwicklung nicht mehr gewährleistet ist.

**Tabelle 1**

| Entwicklungslösemittel | Viskosität [cSt] für verschiedene Feststoffgehalte [Gew.-%] | | |
|---|---|---|---|
| | 5 | 7,5 | 10 |
| 1,3,5-Trimethylbenzol (Mesitylen) | 11,4 | 26,5 | 60 |
| 4-iso-Propyl-4-toluol | 15,8 | 35,4 | 76 |
| Gemisch aus Beispiel 1 | 15 | 35,5 | 77 |
| Perchlorethylen | 37,1 | 120,8 | 333,5 |

### Beispiel 13

Eine handelsübliche Flexodruckplatte (®Cyrel LP) auf der Basis von Nitrilkautschuk, die für den Druck mit Benzinfarben geeignet ist, wurde wie in Beispiel 6 angegeben 15 min behandelt. Die Restschichtdicke betrug 0,6 mm.

### Beispiel 14 (Vergleichsbeispiel)

Eine handelsübliche Flexodruckplatte (®Cyrel LP) wurde wie in Beispiel 13 angegeben behandelt. Als Entwicklungslösemittel wurde jedoch Limonen verwendet. Die Platte konnte nicht entwickelt werden.

### Beispiel 15 (Vergleichsbeispiel)

Eine handelsübliche Flexodruckplatte wurde wie in Beispiel 13 behandelt. Als Entwicklungslösemittel wurde jedoch Perchlorethylen zusammen mit 15 Gew.-% n-Butanol benutzt. Die Restschichtdicke betrug nach 15 min Entwicklungszeit 1,21 mm.

## Patentansprüche

1. Verfahren zur Herstellung von durch Photopolymerisation vernetzten Reliefdruckplatten, bei dem man die durch Photopolymerisation vernetzbaren Schichten bildmäßig belichtet und die unvernetzten Anteile der Schichten mit dem Entwicklungslösemittel auswäscht, dadurch gekennzeichnet, daß das Entwicklungslösemittel als wesentlichen Bestandteil eine aromatische Verbindung der allgemeinen Formel I 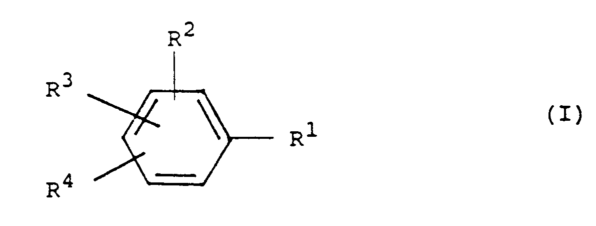 enthält, worin
R¹ bis R⁴ gleich oder verschieden sind und H, (C₁-C₅)n- oder iso-Alkyl bedeuten, wobei R¹ und R², sofern sie direkt benachbart sind, auch einen cycloaliphatischen oder aromatischen Ring mit 5 oder 6 Ring-C-Atomen ausbilden können, die bevorzugt nicht substituiert sind,
mit der Maßgabe, daß die Summe der Kohlenstoffatome oder Substituenten und der Ringglieder 9 bis 13 beträgt.

2. Verfahren gemäß Anspruch 1, dadurch gekennzeichnet, daß das Entwicklungslösemittel 55 bis 100 Gew.-%, bevorzugt 55 bis 90 Gew.-%, einer aromatischen Verbindung der allgemeinen Formel I enthält.

3. Verfahren gemäß Anspruch 1 oder 2, dadurch gekennzeichnet, daß das Entwicklungslösemittel zusätzlich einen höhersiedenden Alkohol enthält.

4. Verfahren gemäß Anspruch 1, 2 oder 3, dadurch gekennzeichnet, daß man die Reliefdruckplatte nach dem Auswaschen bei Temperaturen bis 120 °C trocknet und gegebenenfalls gleichzeitig oder danach mit aktinischem Licht nachbelichtet.

## Claims

1. Process for preparation of relief printing plates crosslinked by photopolymerization, wherein the layers crosslinkable by photopolymerization are exposed imagewise and the parts of the layers which are not crosslinked are washed out with the developer solvent, characterized in that the developer solvent contains as essential part an aromatic compound of the general formula I 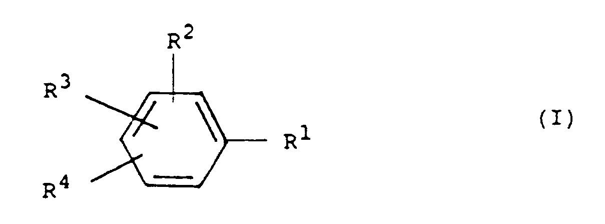 wherein
R1 through R4 are equal or different and mean H, (C1-C5)n- or iso-alkyl, and wherein R1 and R2, when being immediate neighbors, can also form a cycloaliphatic or aromatic ring having 5 or 6 carbon atoms, which are preferentially unsubstituted,
with the proviso that the sum of the carbon atoms of the substituents and of the members of the ring is 9 to 13.

2. Process according to claim 1, characterized in that the developer solvent contains 55 to 100 percent by weight, preferentially 55 to 90 percent by weight, of an aromatic compound of the general formula I.

3. Process according to claim 1 or 2, characterized in that the developer solvent contains in addition a higher boiling alcohol.

4. Process according to claim 1, 2 or 3, characterized in that the relief printing plate after wash-out is dried at temperatures up to 120 °C and is optionally exposed to actinic light either simultaneously or thereafter.

## Revendications

1. Procédé de fabrication de plaques d'impression en relief réticulées par photopolymérisation, dans lequel on expose de façon à former une image des couches réticulables par photopolymérisation et l'on élimine par lavage les parties non réticulées des couches à l'aide du solvant de développement, caractérisé en ce que le solvant de développement contient comme constituant essentiel un dérivé aromatique répondant à la formule générale I: 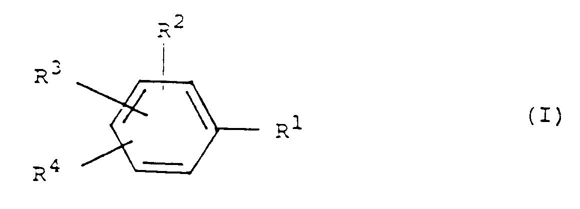 dans laquelle:
R¹ à R⁴ peuvent être identiques ou différents et représentent H, un radical n-alkyle ou isoalkyle en C₁ à C₅, R¹ et R², pour autant qu'ils occupent une position directement voisine, peuvent former un cycle cycloaliphatique ou aromatique renfermant dans le cycle 5 ou 6 atomes de carbone, de préférence non substitués,
étant entendu que la somme des atomes de carbone des substituants et des éléments du cycle est égale à 9 à 13, bornes comprises.

2. Procédé selon la revendication 1, caractérisé en ce que le solvant de développement contient de 55 à 100% en poids, de préférence 55 à 90% en poids d'un dérivé aromatique de formule générale I.

3. Procédé selon la revendication 1 ou 2, caractérisé en ce que le solvant de développement contient en outre un alcool à point d'ébullition élevé.

4. Procédé selon la revendication 1, 2 ou 3, caractérisé en ce que la plaque d'impression en relief, après lavage à des températures atteignant jusqu'à 120°C, est séchée et éventuellement traitée simultanément ou après coup par exposition à une radiation actinique.
